# EUROPÄISCHE PATENTSCHRIFT

(11) **EP 0 815 599 B1**
(45) Veröffentlichungstag und Bekanntmachung des Hinweises auf die Patenterteilung: **22.09.1999**
(21) Anmeldenummer: 96905658.9
(22) Anmeldetag: 15.03.1996
(51) Int. Cl.: H01L 39/14

(54) **ELEKTRISCHER LEITER MIT SUPRALEITENDEN KERNEN UND VERFAHREN ZUR HERSTELLUNG EINES SOLCHEN LEITERS**
ELECTRICAL CONDUCTOR WITH SUPERCONDUCTING CORES, AND METHOD OF MANUFACTURING SUCH A CONDUCTOR
CONDUCTEUR ELECTRIQUE DOTE DE PLUSIEURS AMES SUPRACONDUCTRICES ET METHODE DE FABRICATION D'UN TEL CONDUCTEUR

(30) Priorität: 15.03.1995 CH 73695
(43) Veröffentlichungstag der Anmeldung: 07.01.1998
(73) Patentinhaber: Université de Genève, représentée par son Département de physique de la matière condensée, 1211 Genève 4 (CH)
(72) Erfinder: FLÜKIGER, René, L., J., CH-1228 Plan-les-Ouates (CH); GOLDACKER, Wilfried, D-69121 Heidelberg (DE)
(74) Vertreter: Zbinden, Paul A.
(86) Internationale Anmeldenummer: CH9600101
(87) Internationale Veröffentlichungsnummer: WO9628853

(56) Entgegenhaltungen:
- EP-A- 0 358 779
- EP-A- 0 412 527
- WO-A-89/06053

## Beschreibung

### Technisches Gebiet

Die Erfindung betrifft einen elektrischen Leiter mit mindestens zwei supraleitenden Kernen und ein Verfahren zur Herstellung eines elektrischen Leiters mit mindestens zwei supraleitenden Kernen.

Die Kerne werden häufig auch als Filamente bezeichnet. Ein Leiter mit mehreren Kernen bzw. Filamenten wird häufig als Vielkern- bzw. Multifilament-Leiter bezeichnet.

Die Kerne bzw. Filamente bestehen vorzugsweise aus Metalloxiden bzw. Keramik. Jeder Kern kann zum Beispiel Oxide von Wismuth, Strontium, Calcium und Kupfer aufweisen, die beim fertigen Leiter mindestens zum grössten Teil aus einer supraleitenden, texturierten Phase bestehen. Diese kann näherungsweise durch die Formel Bi₂Sr₂Ca₂Cu₃O₁₀ dargestellt werden und wird häufig kurz mit Bi(2223) bezeichnet, wobei die in der Klammer enthaltenen Zahlen die Anzahl Atome der vier Elemente Bi, Sr, Ca, Cu angeben. Im allgemeinen enthält die die supraleitende Phase bildende Verbindung zur thermodynamischen Stabilisierung noch einen gewissen Anteil Blei, was zum Beispiel durch die Formel Bi_{1,72}Pb_{0,34}Sr_{1,83}Ca_{1,97}Cu_{3,13}O₁₀₋ₓ ausgedrückt, aber durch dieselbe Bezeichnung Bi(2223) bezeichnet wird. Weiter kann die als supraleitende Phase dienende Verbindung zur Erhöhung der kritischen Stromdichte noch einen gewissen Anteil von mindestens einem anderen Oxid - wie zum Beispiel von Magnesiumoxid und/oaer Titanoxid - enthalten, wird aber durch dieselbe Abkürzung Bi(2223) bezeichnet. Die Sprungtemperatur der supraleitenden Phase Bi(2223) kann zwischen 110 K und 115 K liegen.

Es gibt auch noch eine andere supraleitende, kristalline Phase, welche Oxide von Wismuth, Blei, Strontium, Calcium, Kupfer und eventuell Blei aufweist, bzw. aus solchen Oxiden gebildet ist. Diese Phase kann durch die Formel Bi₂Sr₂Ca₁Cu₂O₈₋ₓ dargestellt werden und wird im folgenden kurz mit Bi(2212) bezeichnet. Die Sprungtemperatur der Phase Bi(2212) kann je nach Herstellungsbedingungen zwischen 60 K und einem maximalen Wert von 94 K liegen. Die Phase Bi(2223) hat also eine höhere Sprungtemperatur als die Phase Bi(2212) und kann zudem bei 77 K, der Temperatur des flüssigen Stickstoffs, supraleitende Ströme bis zu wesentlich stärkeren Magnetfeldern tragen als die Phase Bi(2212). Die Phase Bi(2223) ist daher für viele Verwendungen günstiger.

Des weiteren gibt es noch eine supraleitende, kristalline Phase, welche Oxide von Thallium, Strontium, Calcium, Kupfer und eventuell Blei und/oder Wismuth aufweist, bzw. aus solchen gebildet ist. Diese Phase kann durch die Formel Tl₁Sr₂Ca₂Cu₃O₉ dargestellt werden, und wird im folgenden kurz mit Tl(1223) bezeichnet. Die Sprungtemperatur der Phase Tl(1223) liegt zwischen 120 K und 125 K. Diese Sprungtemperatur ist noch höher als diejenige von Bi(2223) und wäre also sehr günstig. Die Phase Tl(1223) hat jedoch den Nachteil, dass sie nach dem gegenwärtigen Wissensstand nur wenig texturiert werden kann.

Ferner können die Kerne Oxide von Yttrium, (Calcium,) Barium und Kupfer mit den ungefähren Formeln YBa₂Cu₃Oₓ oder Y_{0,9} Ca_{0,1}Ba₂Cu₄O₈ aufweisen, wobei x 6 bis 7 beträgt. Diese beiden supraleitenden Phasen werden üblicherweise kurz mit Y(123) bzw. Y(124) bezeichnet.

Zudem können die Kerne Oxide von Quecksilber, Barium und Kupfer aufweisen.

### Stand der Technik

Bei einem bekannten Verfahren für die Herstellung eines elektrischen Leiters mit mehreren supraleitenden, aus Oxiden bestehenden Kernen bzw. Filamenten bildet man zuerst einen aus Silber bestehenden Zylinder mit einer Anzahl zur Achse parallelen Löcher und füllt ein teilchenförmiges, zur Bildung der Kerne dienendes Material in diese ein (vgl. z. B. die DE-A 44 21 163). Bei einem andern bekannten Verfahren füllt man ein Kernbildungsmaterial in aus Silber bestehende Rohre ein und fasst mehrere solcher Rohre zu einem Bündel zusammen (vgl. z.B. die Publikation "Dependence of critical current density on filament diameter in round multifilament Agsheathed Bi₂Sr₂CaCu₂Oₓ wires processed in O₂", L. R. Motowidlo, G. Galinski, G. Ozeryansky W. Zhang E. E. Hellstrom; Appl. Phys. Lett. 65, 21. November 1994, 2731 - 2733, American Institute of Physics).

Der gefüllte Löcher aufweisende Zylinder bzw. das Bündel gefüllter Rohre bildet dann einen stabförmigen Leiter und wird in mehreren Schritten durch plastische Verformungen verlängert und zu einem band- oder drahtförmigen Leiter umgeformt. Der Leiter wird im Verlauf der Herstellung mindestens einer Wärmebehandlung, nämlich einer Reaktionsglühung unterzogen, um das Kernbildungsmaterial in eine supraleitende, kristalline Phase umzuwandeln. Wenn der Leiter aus einem Silberzylinder mit mehreren Löchern gebildet wurde, besitzt der fertige Leiter eine zusammenhängende Silber-Matrix, in welche die supraleitenden Kerne eingebettet sind. Wenn der Leiter aus einem Bündel von gefüllten Rohren hergestellt wird, bildet jedes am Anfang des Herstellungsverfahrens mit Kernbildungsmaterial gefüllte Rohr einen Mantel, der einen Kern des fertigen Leiters im Querschnitt umhüllt. Die verschiedenen, je aus einem Rohr entstandenen Mäntel liegen dann beim fertigen Leiter fest aneinander an, so dass sie zusammen quasi ebenfalls eine mehr oder weniger zusammenhängende Matrix bilden.

Die Matrix bzw. die Mäntel aus Silber können bei der Verwendung eines Leiters Unterbrüche zwischen den supraleitenden Kristalliten der einzelnen Kerne elektrisch leitend überbrücken. Die hohe, elektrische Leitfähigkeit des Silbers ergibt jedoch nicht nur in der Längsrichtung der Kerne einen niedrigen, elektrischen Längswiderstand, sondern auch einen niedrigen, elektrischen Querwiderstand zwischen den verschiedenen Kernen. Bei der Verwendung eines derartigen, bekannten Leiters zum Leiten eines Wechselstroms können daher innerhalb des Leiters Wirbelströme mit Strom-Wirbeln entstehen, bei denen Strom in einander entgegengesetzte Richtungen durch Abschnitte verschiedener supraleitender Kerne strömt. Dies ist insbesondere dann der Fall, wenn der Leiter eine Wicklung eines Transformators oder eine sonstige Wicklung bildet. Die Wirbelströme verursachen dann grosse Verluste von elektrischer Energie.

Ferner sind aus der EP-A 0 412 527 Leiter mit einem supraleitenden Kern und einem diesen umschliessenden, gut elektrisch leitenden Mantel aus Silber oder Kupfer bekannt, wobei mindestens ein Abschnitt des Mantels ein zusätzliches Metall - beispielsweise Zink, Palladium oder Nickel - enthält, so dass dieser Abschnitt eine kleinere Wärmeleitfähigkeit oder kleinere elektrische Leitfähigkeit hat als Silber bzw. Kupfer. Für die Herstellung einer derartigen Leiters wird eine dünne Schicht des zusätzlichen Metalls auf den Silber- bzw. Kupfermantel aufgebracht. Anschliessend wird der Leiter in einer Argon-Umgebung erhitzt, so dass das zusätzliche Metall in den Mantel hineindiffundiert und in diesem verteilt sowie gelöst wird.

Das Hineindiffundieren eines der genannten zusätzlichen Metalle in den aus Silber oder Kupfer bestehenden Mantel ergibt jedoch nur eine relativ kleine Erhöhung des spezifischen elektrischen Widerstandes. Zudem kann beim Hineindiffundieren des zusätzlichen Metalls in den Mantel zusätzliches Metall in den supraleitenden Kern eindringen und dessen Supraleitfähigkeit beeinträchtigen.

Gemäss der EP-A 0 412 527 wird das zusätzliche Metall erst dann in den aus Silber oder Kupfer bestehenden Mantel eingebracht, wenn die Umformvorgänge, thermischen Behandlungen und chemischen Reaktionen beendet sind, durch welche der Kern sowie der Mantel die vorgesehenen Querschnittsformen sowie Querschnittsabmessungen erhalten und der Kern supraleitend gemacht wird. Dies ist mindestens in den meisten Fällen praktisch auch gar nicht anders möglich. Wenn man nämlich einen Leiter erst nach dem Hineindiffundieren eines zusätzlichen Metalls in den Mantel in Sauerstoff-Umgebung glühen würde, um den Kern supraleitend zu machen, würde das im Mantel gelöste und verteilte, zusätzliche Metall oxidieren und Inseln bilden. Dies hätte wiederum zur Folge, dass die ohnehin nur geringe Vergrösserung des elektrischen Widerstands zum grössten Teil wieder rückgängig gemacht würde. Zudem würde die Duktilität und damit die Verformbarkeit des Mantels verschlechtert. Mit dem aus der EP-A 0 412 527 bekannten Verfahren kann man daher praktisch nur Drähte oder Bänder herstellen, die mindestens etwa 0,3 mm dick sind. Für viele Zwecke sind jedoch Leiter mit mehreren Kernen erwünscht, die weniger als 0,1 mm und noch besser weniger als 0,03 mm dick sind.

### Abriss der Erfindung

Der Erfindung liegt die Aufgabe zugrunde, einen Leiter und ein Verfahren zur Herstellung eines solchen zu schaffen, die bzw. das Nachteile der bekannten Leiter und Herstellungsverfahren vermeidet, wobei insbesondere ein Leiter geschaffen bzw. durch das Verfahren herstellbar sein soll, bei welchem zwischen den verschiedenen Kernen ein grosser elektrischer Querwiderstand vorhanden ist, Unterbrüche eines einzelnen Kerns aber trotzdem gut elektrisch leitend überbrückt werden.

Diese Aufgabe wird gemäss der Erfindung durch einen Leiter gemäss dem Anspruch 1 und durch ein Verfahren gemäss dem Anspruch 15 gelöst.

Vorteilhafte Weiterbildungen des Leiters und des Verfahrens gehen aus den abhängigen Ansprüchen hervor.

Jeder längliche, supraleitende Kern des erfindungsgemässen Leiters bzw. des durch das erfindungsgemässe Verfahren hergestellten Leiters ist von einem elektrisch leitenden Mantel umschlossen, der von einer mindestens ein Metalloxid aufweisenden Hülle umhüllt ist, deren spezifischer elektrischer Widerstand grösser ist als derjenige des Mantels.

Die Hüllen bestehen zweckmässigerweise mindestens zum grössten Teil, vorzugsweise mindestens annähernd vollständig und zum Beispiel vollständig sowie ausschliesslich aus einem Metalloxid oder aus mehreren Metalloxiden. Zudem besitzen die Hüllen vorzugsweise durchgehende Poren und/oder sind sonst derart ausgebildet, dass sie bei noch näher beschriebenen Vorgängen der Herstellung des Leiters und beispielsweise auch beim fertigen Leiter gasdurchlässig und insbesonders sauerstoffdurchlässig sind. Wie es ebenfalls noch näher angegeben wird, sind die Hüllen unter anderem wegen der gewünschten Sauerstoffdurchlässigkeit vorzugsweise relativ dünn bemessen.

Die Hüllen sind im Idealfall vollkommen elektrisch isolierend. Wenn die Hüllen dünn und porös ausgebildet werden, kann dies eventuell die elektrische Isolationswirkung der Hüllen beeinträchtigen, auch wenn diese vollständig aus einem Metalloxid oder aus mehreren Metalloxiden bestehen. Der spezifische elektrische Widerstand der Hüllen ist jedoch vorzugsweise mindestens 10-mal, besser mindestens 100-mal und zum Beispiel mindestens 1000-mal grösser als derjenige der von den Hüllen umhüllten Mäntel. Ferner ist der elektrische Widerstand jeder Hülle in einer quer und ungefähr rechtwinklig zu ihrer Längsrichtung und der Längsrichtung des von ihr umschlossenen Kerns sowie Mantels verlaufenden Richtung zweckmässigerweise mindestens 10-mal, vorzugsweise mindestens 100-mal und noch besser mindestens 1000-mal grösser als der in der gleichen Richtung gemessene Widerstand des von der betreffenden Hülle umschlossenen Mantels.

Die elektrisch leitenden Mäntel überbrücken allfällige Unterbrüche der von ihnen umhüllten Kerne elektrisch leitend mit kleinem Längswiderstand, während die verschiedenen Kerne durch die elektrisch isolierenden Hüllen gegeneinander mehr oder weniger vollkommen isoliert werden. Wenn aus dem Leiter eine Wicklung für einen Transformator oder eine sonstige Wicklung gebildet und Wechselstrom durch diese hindurch geleitet wird, können daher keine oder höchstens schwache durch mehrere verschiedene Kerne verlaufende Strom-Wirbel bzw. Strom-Schleifen entstehen. Dementsprechend können Verluste von elektrischer Energie infolge von Wirbelströmen stark reduziert oder sogar nahezu vollständig vermieden werden.

Die Kerne bestehen vorzugsweise aus Metalloxiden bzw. Keramik und weisen zum Beispiel die supraleitende Phase Bi(2223) oder eine der anderen, weiter vorne angegebenen, supraleitenden Phasen auf.

Die Kerne werden beim Herstellen eines Leiters vorzugsweise aus einer Mischung von Metallverbindungen, insbesondere Metalloxiden gebildet, wobei die Mischung eventuell ursprünglich auch noch mindestens ein Carbonat enthalten kann, dass dann in ein Oxid umgewandelt wird. Die Mischung wird bei mindestens einer Wärmebehandlung durch eine Reaktion zu einem möglichst grossen Teil in eine gewünschte, supraleitende Phase umgewandelt. Für die Herstellung eines Leiters kann man zum Beispiel zuerst ein teilchenförmiges, elektrisch noch nicht-leitendes Gemisch von Metalloxiden und eventuell mindestens einem Carbonat herstellen und dieses als Kernbildungsmaterial dienende Gemisch in zur Bildung von Mänteln des Leiters dienende Rohre einfüllen. Die Umwandlung des Oxidgemisches in die gewünschte supraleitende Metalloxid-Phase kann dann später bei mindestens einer Wärmebehandlung und normalerweise bei mehreren solchen erfolgen. Es besteht jedoch auch die Möglichkeit, das Kernbildungsmaterial schon vor dem Umschliessen mit Mänteln durch mindestens eine Wärmebehandlung mindestens zum Teil in eine supraleitende Metalloxid-Phase umzuwandeln.

Gemäss der Erfindung bildet man bei der Herstellung des Leiters für jedem Kern von diesem ein Werkstück, das einen im Querschnitt von einem Mantel umschlossenen, zum Beispiel aus teilchenförmigem Kernbildungsmaterial bestehenden Kern und eine diese im Querschnitt umschliessende Hülle aufweist. Gemäss der Erfindung werden die Werkstücke dann gemeinsam verformt und mindestens einer Wärmebehandlung unterzogen. Dabei werden die Materialien der Werkstücke mindestens zum Teil auch chemisch verändert. Die Kerne, Mäntel und Hüllen werden daher in ihrem Ausgangs-Zustand, den sie aufweisen, bevor die Werkstücke gemeinsam umgeformt und gemeinsam mindestens einer Wärmebehandlung unterzogen werden, im folgenden auch als Ausgangs-Kerne bzw. Ausgangs-Mäntel bzw. als Ausgangs-Hüllen bezeichnet.

Die Ausgangs-Hüllen der Werkstücke werden bei der Herstellung der letzteren zum Beispiel noch mit einem äusseren Mantel umschlossen. Ferner werden die zur Bildung eines Leiters dienenden Werkstücke vor dem gemeinsamen Verformen der Werkstücke vorzugsweise mit einem sie im Querschnitt umschliessenden Bündel-Mantel bzw. Rohr zu einem Bündel verbunden. Die allenfalls vorhandenen, äusseren Mäntel der Werkstücke und der allenfalls vorhandene Bündel-Mantel werden, bevor die Werkstücke gemeinsam verformt und gemeinsam mindestens einer Wärmebehandlung unterzogen werden, auch als äussere Ausgangs-Mäntel bzw. Ausgangs-Bündel-Mantel bezeichnet.

Wenn zwei oder mehr Werkstücke zum gemeinsamen Verformen miteinander verbunden werden, bilden sie zusammen einen Leiter. Dieser wird in seinem vor dem gemeinsamen Verformen der Werkstücke und vor der gemeinsamen Wärmebehandlung vorliegenden Zustand auch als Ausgangs-Leiter bezeichnet.

Jeder zum Beispiel durch ein Rohr gebildete Ausgangs-Mantel besteht vorzugsweise mindestens zum grössten Teil aus einem metallischen Silber aufweisenden Material. Jeder Ausgangs-Mantel kann zum Beispiel aus reinem Silber oder aus einer Silber-Legierung oder aus einem Silber-Komposit bestehen. Eventuell kann der Ausgangs-Mantel auch zwei oder mehr elektrisch leitende Schichten aus verschiedenen, silber-haltigen Materialien aufweisen, wobei zum Beispiel eine aus reinem Silber und mindestens eine aus einer Silber-Legierung und/oder mindestens eine aus einem Silber-Komposit bestehende Schicht vorhanden sein kann. Jeder Ausgangs-Mantel kann ferner zwei oder mehr Schichten besitzen, die aus verschiedenen Silber-Legierungen oder aus mindestens einer Silber-Legierung bzw. mindestens einem Silber-Komposit oder aus verschiedenen Silber-Kompositen bestehen.

Eine allenfalls den Ausgangs-Mantel oder mindestens eine Schicht des Ausgangs-Mantels bildende Legierung kann zusätzlich zu Silber zum Beispiel noch mindestens eines der Metalle Gold, Kupfer, Magnesium, Titan oder Aluminium enthalten. Zur Klarstellung sei angemerkt, dass der Begriff "Legierung" hier auch ein eutektisches Gemisch oder eine intermetallische Verbindung umfassen soll. Falls die Silber-Legierung Gold aufweist, bleibt diese bei der bzw. jeder Wärmebehandlung in metallischem Zustand, so dass also auch jeder einen einzelnen Kern des fertigen Mantels umschliessende Mantel mindestens zum Teil aus einer Silber-Gold-Legierung besteht. Wenn die Ausgangs-Mäntel hingegen zusätzlich zu Silber als Legierungskomponente noch mindestens eines der Metalle Kupfer, Magnesium, Titan, Aluminium aufweisen, wird dieses Metall bzw. jedes dieser Metalle bei der Wärmebehandlung bzw. den Wärmebehandlungen normalerweise mindestens zum grössten Teil oxidiert. Die Mäntel des fertigen Leiters weisen dann ein Silber-Komposit mit einer aus Silber und gegebenenfalls Gold bestehenden Matrix und in dieser verteilte Metalloxid-Partikel auf.

Wie beschrieben, können eventuell bereits die Ausgangs-Mäntel mindestens zum Teil aus einem Silber-Komposit bestehen. In einem solchen Fall können die Ausgangs-Mäntel ein aus Silber oder einer Silber-Legierung bestehende Matrix aufweisen, in der feine Partikel dispergiert sind; die aus einem Oxid von mindestens einem der Metalle Kupfer, Magnesium, Titan und Aluminium bestehen.

Wenn die Mäntel des fertigen Leiters Gold und/oder ein Oxid von mindestens einem der Elemente Kupfer, Magnesium und Titan enthalten, wird dadurch der spezifische elektrische Widerstand gegenüber demjenigen von reinem Silber vergrössert. Wenn die Mäntel der fertigen Leiter Aluminiumoxid - d. h. Al₂O₃ - enthalten, vergrössert dies den spezifischen, elektrischen Widerstand ebenfalls, gibt aber vorallem auch eine Verbesserung gewisser mechanischer Eigenschaften.

Gemäss der Erfindung wird jeder einem Kern zugeordnete und diesen im Querschnitt umschliessende, elektrisch leitende Ausgangs-Mantel bei der Herstellung des Leiters mit einer Ausgangs-Hülle versehen, die den Ausgangs-Mantel im Querschnitt umschliesst. Die Ausgangs-Hüllen weisen gemäss der Erfindung mindestens ein oxidierbares Metall auf und bestehen vorzugsweise mindestens zum grössten Teil oder vollständig aus einem oxidierbaren, metallischen Material. Falls die Ausgangs-Hüllen ein metallisches Material mit mehreren Metallen aufweisen, können diese zusammen eine Legierung oder ein eutektisches Gemisch oder eine intermetallische Verbindung bilden.

Das die Ausgangs-Hüllen bildende, mindestens zum Teil metallische Material soll vorzugsweise duktil sein, damit die Hüllen beim Umformen des Leiters ebenfalls umgeformt werden können, ohne zu brechen. Die Hüllen sollen vorzugsweise derart duktil sein, dass ihre Querschnittsflächen - wie wie auch diejenigen der anderen Teile des Leiters - bei der Umformung den letzteren durch plastische Verformung vorzugsweise mindestens 100-mal, noch besser mindestens 1'000-mal und zum Beispiel mindestens 10'000-mal verkleinert werden können, ohne zu brechen.

Die Ausgangs-Hüllen können zum Beispiel aus mindestens einem der Metalle Kupfer, Aluminium, Nickel, Eisen, Magnesium, Titan, Zirkonium, Calcium, Zinn, Niob, Vanadium, Tantal, Hafnium gebildet werden. Das bzw. jedes dieser Metalle kann dann im Verlauf von mindestens einer auch zur Umwandlung des Materials der Kerne in eine supraleitende Phase dienenden, in sauerstoffhaltiger Umgebung erfolgenden Wärmebehandlung und beispielsweise während mehrerer solcher Wärmebehandlungen oxidiert werden, so dass die Hüllen des fertigen Leiters dann ein Oxid von einem bzw. mehreren dieser Metalle aufweisen.

Es besteht jedoch die Möglichkeit, die Ausgangs-Hüllen aus einem Material zu bilden das zusätzlich zu mindestens einer metallischen Komponente bereits mindestens ein Metalloxid enthält. Die Ausgangs-Hüllen können dann zum Beispiel aus einer metallischen Matrix bestehen, in der Partikel mindestens eines Metalloxids dispergiert sind. Die Ausgangs-Hüllen können zum Beispiel aus Kupfer oder einer Kupfer-Legierung bestehen, in der Partikel aus der Aluminiumoxid - d. h. Al₂O₃ - dispergiert sind.

Wenn man den Leiter im Verlauf des Verfahrens mindestens einer Wärmebehandlung in sauerstoffhaltiger Umgebung unterzieht, wird das bzw. mindestens eines und vorzugsweise jedes in den Ausgangs-Hüllen enthaltene Metall mindestens zum Teil, vorzugsweise mindestens zum grössen Teil und zum Beispiel annähernd vollständig oder am besten vollständig oxidiert. Die dann beim fertigen Leiter mindestens zum Teil, vorzugsweise zum grössten Teil und zum Beispiel mindestens annähernd vollständig aus einem Metalloxid oder einem Metalloxidgemisch bestehenden Hüllen haben dann einen grossen spezifischen elektrischen Widerstand.

Die Hüllen werden vorzugsweise relativ dünn bemessen, so dass ihre Dicke beim fertigen Leiter zweckmässigerweise höchstens 10 µm, vorzugsweise höchstens 5 µm, und zum Beispiel ungefähr 0,1 µm bis 1 µm beträgt. Durch diese dünne Ausbildung der Hüllen des fertigen Leiters kann erreicht werden, dass die ursprünglich dicken, im Verlauf der Umformung des Leiters dünner werdenden Hüllen mindestens nach dem letzten zum Beispiel durch Walzen erfolgenden Umformungsvorgang und vorzugsweise schon vor diesem durchgehende Poren aufweisen. Die Hüllen sind dann vorzugsweise mindestens bei der Wärmebehandlung und beispielsweise bei allen auch zur UMwandlung der Kerne dienenden Wärmebehandlungen - wie auch die mindestens zum Teil aus Silber bestehenden Mäntel - für Sauerstoff durchlässig. Die Dicke der Hüllen kann zum Beispiel aufgrund von Versuchen derart festgelegt werden, dass die Hüllen bei der Wärmebehandlung sauerstoffdurchlässig, aber nicht dünner als nötig sind und einen möglichst grossen, elektrischen Widerstand quer zur Längsrichtung der Kerne und Hüllen ergeben.

Der Leiter wird bei seiner Verwendung zum Beispiel mit flüssigem Stickstoff gekühlt und hat dann eine absolute Temperatur von ungefähr 77 K. Wie schon erwähnt, weisen die Mäntel vorzugsweise Silber auf und bestehen zum Beispiel mindestens zum grössten Teil oder vollständig aus Silber. Die Wärmeleitfähigkeit von Silber beträgt bei einer absoluten Temperatur von 77 K ungefähr 5 W/cm Celsius-Grad. Die Wärmeleitzahl der Hüllen beträgt bei einer absoluten Temperatur von 77 K zweckmässigerweise mindestens 0,1 W/cm Celsius-Grad, vorzugsweise mindestens 0,5 W/cm Celsius-Grad und zum Beispiel mindestens 1 W/cm Celsius-Grad. Die Wärmeleitzahl der Hülsen ist dann also zweckmässigerweise mindestens ungefähr 2%, vorzugsweise mindestens ungefähr 10% und zum Beispiel mindestens ungefähr 25% derjenigen von Silber bei gleicher Temperatur.

Hier sei angemerkt, dass Metalloxide bei tiefen Temperaturen zum Teil wesentlich grössere Wärmeleitzahlen haben als bei normaler Raumtemperatur. Zum Beispiel hat Aluminiumoxid bei unterhalb etwa 80 K liegenden Temperaturen - bei denen aus Metalloxide gebildete Kerne supraleitend sind - eine relativ grosse Wärmleitzahl, die bei gewissen Temperaturen ähnliche Wert hat wie die Wärmeleitzahl von Silber. Wenn die Hüllen also zum Beispiel mindestens zum Teil aus Aluminiumoxid bestehen, sind sie daher sowohl elektrisch isolierend als auch relativ gut wärmeleitend. Wenn die Hüllen des fertigen Leiters nebst Aluminiumoxid noch mindestens ein anderes Metalloxid - zum Beispiel Kupferoxid - enthalten, können die Oxide zum Beispiel bei der Herstellung der Ausgangs-Hüllen derart verteilt werden, dass das Aluminiumoxid in jeder Hülle in dieser verteilte Bereiche bildet, welche sich beim fertigen Leiter durch die ganze Dicke der Hülle erstrecken und gewissermassen Wärmeleit-Brücken bilden.

Durch die verhältnismässig grosse Wärmeleitzahl der Hülle bei tiefen Temperaturen und/oder durch die bereits beschriebene, vorzugsweise relativ dünne Ausbildung der Hüllen kann erreicht werden, dass mindestens im wesentlichen aus einem Metalloxid oder mehreren Metalloxiden bestehende Hüllen bei der Verwendung des Leiters noch eine relativ gute Wärmeleitung quer zur Längsrichtung des Leiters der Kerne und Hüllen ermöglichen. Dies trägt bei der Verwendung des Leiters dazu bei, thermische Instabilitäten - d.h. einen Verlust der Supraleitfähigkeit wegen lokalen Erwärmungen - zu vermeiden.

Bei der Herstellung eines Leiters werden mindestens zwei vorzugsweise mindestens drei und zum Beispiel mindestens zehn Werkstücke hergestellt. Diese sind vorzugsweise länglich und zum Beispiel stabförmig sowie relativ formfest oder eventuell bereits eher drahtförmig und relativ gut biegbar. Jede dieser Werkstücke besitzt einen Kernbildungsmaterial umschliessenden Ausgangs-Mantel, eine diesen umschliessende Ausgangs-Hülle und eventuell noch einen äusseren Ausgangs-Mantel. Die Werkstücke können dann zum Beispiel mit einem sie im Querschnitt umschliessenden Bündel-Mantel zusammengehalten und zu einem Bündel verbunden werden.

Die allenfalls vorhandenen, eine Hülle umschliessenden, äusseren Ausgangs-Mäntel und der Ausgangs-Bündel-Mantel können aus einem der Materialien gebildet werden, aus denen die Ausgangs-Mäntel gebildet werden, welche die Kerne umschliessen und unmittelbar an diesen anliegen.

Die Kerne des Leiters werden eventuell bereits bei der Herstellung der Werkstücke und vor allem beim gemeinsamen Umformen der Werkstücke umgeformt. Beim Umformen werden die Kerne, Mäntel und Hüllen gegeneinander gepresst, so dass sie beim fertigen Leiter im wesentlichen überall lückenlos sowie fest aneinander anliegen. Der fertige Leiter ist dementsprechend kompakt und monolithisch. Die Umformung erfolgt vorzugsweise derart, dass die Kerne möglichst stark texturiert werden. Dadurch lässt sich erreichen, dass jeder Kern bei der Verwendung des Leiters supraleitende, plättchenförmige Kristallite aufweist, deren zwei grösste Flächen bei allen im gleichen Kern vorhandenen Kristalliten und vorzugsweise auch in den Kernen des Leiters ungefähr parallel zueinander und zur Längsrichtung des Kerns sind. Zwischen den verschiedenen, einander benachbarten plättchenförmigen Kristalliten sind dann höchstens geringe Zwischenräume vorhanden. Dies trägt zur Erzielung einer grossen kritischen Stromdichte bei.

Beim Formen eines bandförmigen Leiters, können die zum Beispiel aus der Phase bi(2223) oder Bi(2212) bestehenden Kerne derart texturiert werden, dass die plättchenförmigen Kristallite der jeweiligen Phase mehr oder weniger parallel zu den beiden breiten Oberflächen des beim Walzen geformten, bandförmigen Leiters sind und zu den genannten Oberflächen senkrechte, kristallografische c-Achsen haben.

Der Ausgangs-Leiter kann zum Beispiel in mehreren Schritten durch Strangpressen und/oder Hämmern und/oder Ziehen und insbesondere Walzen umgeformt werden. Der fertige Leiter bildet dann vorzugsweise ein flaches Band, das im Querschnitt mehr oder weniger rechteckförmig ist und im Querschnitt zwei längere, gerade, zueinander parallele Seiten bzw. Ränder und zwei kürzere, eventuell ebenfalls gerade oder mindestens zum Teil konvex gebogene Seiten bzw. Ränder hat. Jeder im Leiter vorhandene, supraleitende Kern ist dann ebenfalls im allgemeinen band- oder streifenförmig und im Querschnitt mehr oder weniger rechteckförmig. Die Dicke, d.h. die kleinere, rechtwinklige zu den breiteren Bandflächen gemessene Querschnittsabmessung jedes Kerns beträgt dann zweckmässigerweise weniger als 0,1 mm, vorzugsweise höchstens 50 µm, noch besser höchstens 30 µm und zum Beispiel ungefähr 5 µm bis höchstens oder ungefähr 20 µm. Eine solche dünne Bemessung trägt zu einer praktisch vollständigen Texturierung jedes Kerns bei. Ferner können so dünne Kerne stärker deformiert - insbesondere gedehnt sowie gebogen werden als dickere Kerne, ohne dass Brüche entstehen.

Der Ausgangs-Leiter kann jedoch eventuell auch derart umgeformt werden, dass der fertige Leiter im Querschnitt rundlich und zum Beispiel ungefähr oder genau kreisförmig ist. Die Kerne können dann beispielsweise im zentralen Querschnittsbereich des Leiters im Querschnitt noch ungefähr regelmässige Sechsecke und/oder Kreise bilden und im peripheren Bereich plattgedrückt und mehr oder weniger oval- und/oder rechteckförmig sein. Der Durchmesser oder mindestens eine Querschnittsabmessung jedes Kerns kann dann ebenfalls in den vorgängig für die Dicke der band- bzw. streifenförmigen Kerne angegebenen Bereichen liegen.

Wenn der Leiter im Querschnitt mehr oder weniger kreisförmig ist, können die Kerne - zumindest wenn sie aus der Phase Bi(2212) bestehen - mindestens in dem an die Oberfläche des Leiters angrenzenden Bereich ebenfalls texturiert werden. Die plättchenförmigen Kristallite können dabei derart geordnet werden, dass ihre kristallografischen c-Achsen ungefähr radial zur Längsachse des betreffenden Kerns sind.

Der Leiter wird gemäss der Erfindung mindestens einer Wärmebehandlung, vorzugsweise mindestens zwei und zum Beispiel drei oder noch mehr Wärmebehandlungen in sauerstoffhaltiger Umgebung unterzogen. Der Leiter wird bei der bzw. jeder Wärmebehandlung - der sogenannten Reaktionsglühung - auf eine Temperatur erhitzt, bei welcher ein möglichst grosser Teil des Kernbildungsmaterials in die gewünschte, supraleitende Phase umgewandelt wird. Der Leiter wird bei der bzw. jeder Wärmebehandlung auf eine Temperatur erhitzt, die mindestens im Fall, dass die supraleitende Phase Bi(2223) gebildet werden soll, mindestens 790° C und zum Beispiel 830° C bis 840° C beträgt. Die Dauer der Wärmebehandlung oder - falls mehrere solche stattfinden - die gesamte Dauer der Wärmebehandlungen beträgt vorzugsweise mindestenss 50 Stunden und zum Beispiel 100 Stunden bis 500 Stunden.

Der Leiter ist bei der bzw. jeder Wärmebehandlung zum Beispiel von Luft umgeben, deren Druck zum Beispiel ungefähr oder genau gleich dem Umgebungs-Luftdruck ist und deren Temperatur ungefähr gleich der Temperatur des Leiters ist. Die bzw. mindestens eine oder jede Wärmebehandlung kann eventuell stattdessen in einer Kammer stattfinden, die Luft enthält, deren Druck grösser als der normale Umgebungs-Luftdruck ist. Der Leiter kann sich bei der bzw. jeder Wärmebehandlung stattdessen eventuell in einer Kammer befinden, die reinen Sauerstoff enthält, dessen Druck zum Beispiel ungefähr gleich dem Umgebungs-Luftdruck ist.

Des weiteren kann die bzw. jede Wärmebehandlung des Leiters eventuell in einer Kammer durchgeführt werden, die ein Sauerstoff aufweisende Gas enthält, dessen Druck wesentlich grösser ist als der Umgebungs-Luftdruck und vorzugsweise mindestend 0,5 MPa, noch besser mindestens 1 MPa und zum Beispiel 10 MPa bis 100 MPa beträgt. Dieses Gas ist dann vorzugsweise durch ein nur zum Teil aus Sauerstoff bestehendes Gemisch gebildet, das zusätzlich zu Sauerstoff beispielsweise noch Stickstoff und/oder eine andere Komponente aufweist. Der Partialdruck des im Gas oder - genauer gesagt - Gasgemisch vorhandenen Sauerstoffs beträgt dann vorzugsweise 10 kPa bis 50 kPa und ist zum Beispiel ungefähr gleich gross wie der Sauerstoff-Partialdruck von Luft, deren Druck gleich dem normalen Umgebungs-Luftdruck ist.

Die Hüllen können beim Oxidieren des bzw. mindestens einer ursprünglich in ihnen vorhandenen Metalls eventuell ihre Volumina vergrössern und gewissermassen aufquellen. Dies kann zur erwünschten Bildung von Poren beitragen, um die Hüllen für Sauerstoff durchlässig zu machen. Wenn die Wärmebehandlung(en) und die dabei stattfindende Oxidation - wie es vorgängig als Möglichkeit beschrieben wurde in einem im Vergleich zum Umgebungs-Luftdruck einen grossen Druck aufweisenden Gas durchgeführt wird, wirkt der Druck dieses Gases der Volumenvergrösserungen der Hüllen während des Oxidationsvorgangs entgegen und verhindert oder reduziert diese Volumenvergrösserungen.

### Kurze Beschreibung der Zeichnung

Der Erfindungsgegenstand und weitere Vorteile von diesem werden nun anhand in der Zeichnung dargestellter Ausführungsbeispiele erläutert. In der Zeichnung zeigt
die Fig. 1 einen Querschnitt durch ein schräg angeordnetes zylindrisches, stabförmiges Werkstück, das zur Bildung eines Kerns und diesen umhüllender Teile eines Leiters dient,
die Fig. 2 einen Querschnitt durch ein schräg angeordnetes, aus dem in der Fig. 1 ersichtlichen Werkstück durch Umformen gebildetes, im Querschnitt sechseckförmiges Werkstück,
die Fig. 3 einen Querschnitt eines Ausgangs-Leiters mit einem Bündel gemäss der Fig. 2 ausgebildeter Werkstücke,
die Fig. 4 eine schematische Endansicht von einem Teil des durch Umformen aus dem in der Fig. 4 ersichtlichen Ausgangs-Leiters gebildeten Leiters und
die Fig. 5 eine schematische Endansicht von einem Teil eines andern Leiters.

### Beschreibung der bevorzugten Ausführungsbeispiele

Zur Herstellung eines beispielsweise bandförmigen Leiters mit mehreren supraleitenden, zum Beispiel die Phase Bi(2223) aufweisenden Kernen werden als Ausgangsstoffe Oxide und Carbonate der Metalle Wismuth, Blei, Strontium, Calcium und Kupfer bereitgestellt. Man kann zum Beispiel die folgenden Oxide sowie Carbonate verwenden: Bi₂O₃, PbO, SrCO₃, CaCO₃ und CuO. Es sei jedoch angemerkt, dass auch andere Oxide und Carbonate oder Vorläufer-Stoffe von solchen benutzt werden können.

Die Oxide und Carbonate werden durch Ausfällen und/oder Mahlen zu einem feinkörnigen Pulver verarbeitet und miteinander gemischt, so dass ein Pulvergemisch entsteht, das als teilchenförmiges Kernbildungsmaterial dient. Die Mengenverhältnisse der verschiedenen Oxide und Carbonate werden beim Mischen derart festgelegt, dass das Kernbildungsmaterial die Metallatome zum Beispiel in der Zusammensetzung Bi_{1,72}Pb_{0,34}Sr_{1,83}Ca_{1,97}Cu_{3,13} enthält.

Das teilchenförmige, ursprünglich elektrisch nicht leitende Kernbildungsmaterial wird mindestens einmal und beispielsweise mehrmals während mehrerer Stunden bei einer Temperatur von ungefähr 800° C in einer Luft enthaltenden Umgebung calciniert. Bei der bzw. jeder zum Calcinieren dienenden Wärmebehandlung wird mindestens ein grosser Teil des im Kernbildungsmaterial - insbesondere in dessen Carbonaten - enthaltenen Kohlenstoffs vom Kernbildungsmaterial abgespalten und in Form von Kohlendioxid an die Umgebung abgegeben. Ferner wird beim Calcinieren bei 800° C bis 820° C eventuell bereits ein Teil des teilchenförmigen Gemischs durch eine Reaktion in die kristalline Phase Bi(2212) umgewandelt. Das calcinierte Kernbildungsmaterial wird gemahlen, so dass Teilchen mit Grössen von beispielsweise höchstens 0,06 mm entstehen.

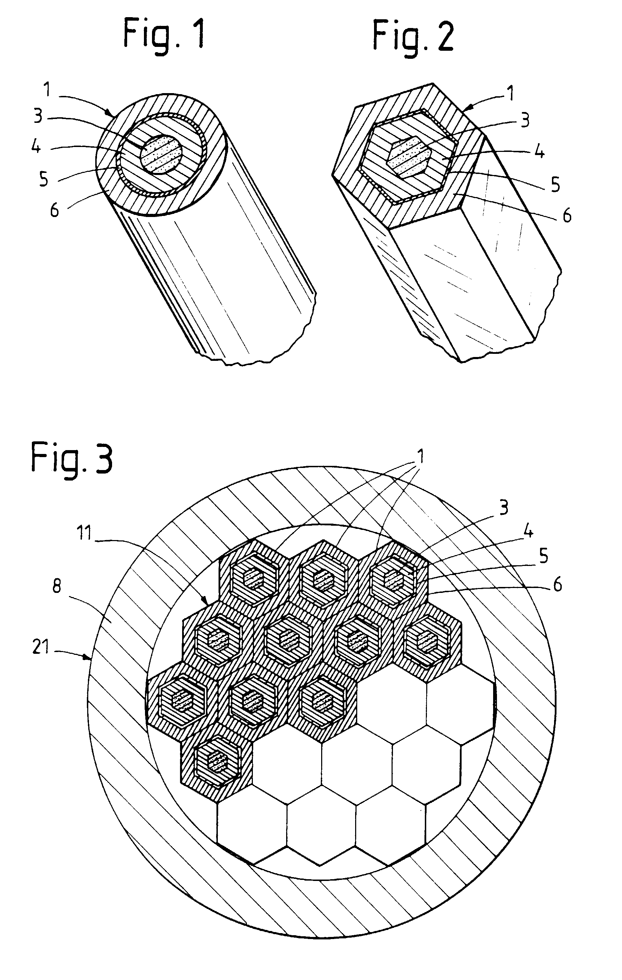

Danach stellt man für jeden zu bildenden Kern des Leiters ein in der Fig. 2 ersichtliches stabförmiges Werkstück 1 her.

Dieses hat einen aus einem hohlzylindrischen Rohr gebildeten, inneren Ausgangs-Mantel 4. Dieser umschliesst im Querschnitt einen aus teilchenförmigem Kernbildungsmaterial bestehenden Ausgangs-Kern 3. Der Innenraum des inneren Ausgangs-Mantels 4 ist an beiden Enden verschlossen, so dass das teilchenförmige Kernbildungsmaterial nicht herausfällt und weder Wasser noch Kohlendioxid aus der Umgebungsluft aufnehmen kann. Der innere Ausgangs-Mantel 4 ist im Querschnitt von einer Hülle 5 umschlossen. Die Hülle 5 ist im Querschnitt ihrerseits von einem äusseren Ausgangs-Mantel 6 umschlossen.

Die Ausgangs-Mäntel 4 und 6 bestehen zum Beispiel aus reinem Silber oder einem der andern in der Einleitung genannten Mantelbildungsmaterialien. Die Ausgangs-Hülle 5 besteht zum Beispiel aus Kupfer oder einem der anderen in der Einleitung genannten Hüllenbildungsmaterialien.

Bei der Herstellung der Werkstücke 1 wird zum Beispiel zuerst für jedes Werkstück ein innerer Ausgangs-Mantel 4 hergestellt, etwa von einem längeren Rohr abgeschnitten. Ferner wird jeder innere Ausgangs-Mantel 4 aussen mit einer Ausgangs-Hülle 5 versehen. Jeder innere Ausgangs-Mantel 4 wird hierzu zum Beispiel in ein galvanisches Bad eingetaucht, aus dem das Kupfer und/oder sonstige, metallische Hüllenbildungsmaterialien durch elektrolytisches Abscheiden auf die Aussenfläche des inneren Ausgangs-Mantels 4 aufgebracht wird. Es besteht jedoch auch die Möglichkeit, ein Hüllenbildungsmaterial statt durch eine elektrolytische Abscheidung oder zusätzlich zu einer solchen durch Aufdampfen (d. h. durch eine "chemical vapor deposition") und/oder durch Aufsprühen auf den inneren Ausgangs-Mantel 4 aufzubringen. Eine weitere Möglichkeit besteht darin, ein Band derart entlang einer Schraubenlinie um den inneren Ausgangs-Mantel 4 zu wickeln, dass das Band die Aussenfläche des Ausgangs-Mantels 4 bedeckt und die Ausgangs-Hülle 5 oder eine Schicht von dieser bildet.

Im übrigen kann man eventuell ein relativ langes, zur Bildung mehrerer innerer Ausgangs-Mäntel 4 dienendes Rohr mit einer Hülle versehen und dieses Rohr dann mitsamt der Hülle in Stücke schneiden, von denen jedes einen inneren Ausgangs-Mantel 4 mit einer Ausgangs-Hülle 5 bildet.

Ferner wird zum Beispiel für jedes zu bildende Werkstück 1 ein äusserer Ausgangs-Mantel 6 hergestellt und zum Beispiel von einem längeren Rohr abgeschnitten. Danach werden der von einer Ausgangs-Hülle 5 umschlossene innere Ausgangs-Mantel 4 und der äussere Ausgangs-Mantel 6 ineinandergesteckt.

Vor oder nach dem Anbringen der Ausgangs-Hülle 5 am inneren Ausgangs-Mantel 4 oder nachdem der innere Ausgangs-Mantel 4 und die Ausgangs-Hülle bereits vom äusseren Ausgangs-Mantel 6 umschlossen sind, wird teilchenförmiges, calciniertes und gemahlenes Kernbildungsmaterial in den vom inneren Ausgangs-Mantel 4 umschlossenen Innenraum eingefüllt und dadurch der Ausgangs-Kern 3 gebildet. Der innere Hohlraum des inneren Ausgangs-Mantels 4 wird dann an beiden Enden verschlossen. Zum Verschliessen des Ausgangs-Mantels 4 können zum Beispiel stopfenartige Abschlusselemente in die Endabschnitte des vom Ausgangs-Mantel 4 umschlossenen Hohlraums eingepresst und/oder durch Hart lötverbindungen mit dem Mantel 4 verbunden werden. Stattdessen könnten die Enden des Ausgangs-Mantels 4 zugequetscht werden.

Jeder innere Ausgangs-Mantel 4 hat zum Beispiel einen Aussendurchmesser von 5 mm bis 10 mm. Der Innendurchmesser jedes inneren Ausgangs-Mantels und der mit diesem Innendurchmesser identische Durchmesser des Ausgangs-Kerns 3 beträgt zum Beispiel 50% bis 80% des Aussendurchmessers des inneren Ausgangs-Mantels 4. Die radial gemessene Dicke der Hülle 5 ist deutlich kleiner als die entsprechend gemessene Dicke des inneren Ausgangs-Mantels 4.

Jedes längliche, zylindrische Werkstück 1 wird beispielsweise durch Ziehen und/oder Pressen zu dem in der Fig. 2 ersichtlichen, im Querschnitt die Form eines regelmässigen Sechsecks aufweisenden, ebenfalls mit 1 bezeichneten Werkstück umgeformt. Diese Umformung erfolgt vorzugsweise durch Kaltverformen, d.h. bei normaler Raumtemperatur. Das Werkstück 1 wird bei dieser Umformung länger sowie dünner und ist dann stab- und oder drahtförmig.

Ferner wird ein in der Fig. 3 ersichtlicher Ausgangs-Bündel-Mantel 8 hergestellt, zum Beispiel von einem längeren Rohr abgeschnitten. Der Mantel 8 besteht zum Beispiel aus reinem Silber oder einem anderen, in der Einleitung genannten Mantelbildungsmaterial. Der Ausgangs-Bündel-Mantel 8 ist zum Beispiel hohlzylindrisch.

Nun werden im Querschnitt sechseckförmige Werkstücke 1 in den Ausgangs-Bündel-Mantel 8 gesteckt, so dass sie ein vom letzteren zusammengehaltenes Werkstück-Bündel 11 bilden. Die Werkstücke 1 liegen mit ihren Flächen paarweise aneinander an und bilden zusammen eine "dichte Packung", welche den Innenraum des Ausgangs-Bündel-Mantels 8 möglichst weitgehend ausfüllt. Der Ausgangs-Bündel-Mantel 8 kann zum Beispiel 9 oder 19 oder 37 oder eine noch grössere, eine "dichte Packung" ermöglichende Anzahl Werkstücke 1 enthalten. Die Abmessungen der Werkstücke 1 und des Ausgangs-Bündel-Mantels 8 sind zum Beispiel derart aufeinander abgestimmt, dass das "dicht gepackte" Werkstück-Bündel derart in den Mantel 8 hineinpasst, dass einige um die Achse des Bündels 11 herum verteilte, Ecken eines dieses einhüllenden, regelmässigen Hüll-Vielecks bildende Werkstücke fest oder mit höchstens kleinem Spiel an der zylindrischen Innenfläche des Ausgangs-Bündel-Mantels 8 anliegen. Das Werkstück-Bündel 11 bildet dann zusammen mit dem Ausgangs-Bündel-Mantel 8 einen mit 21 bezeichneten Ausgangs-Leiter. Der Durchmesser oder - genauer gesagt - Aussendurchmesser des Ausgangs-Leiters beträgt vorzugsweise mindestens 20 mm und zum Beispiel 40 mm bis 120 mm.

Der Ausgangs-Leiter 21 wird nun in mehreren Schritten durch plastisches Verformen umgeformt, d. h. verlängert. Dabei wird die Querschnittsfläche des Leiters sukzessive verkleinert, wobei die in der Fig. 3 ersichtlichen, im Ausgangs-Bündel-Mantel 8 vorhandenen, leeren, d. h. nur Luft enthaltenden Innenraumbereiche verschwinden.

Der eine zylindrische Aussenfläche aufweisende Ausgangs-Leiter 21 wird zum Beispiel zuerst durch Strangpressen und/oder Hämmern und/oder Ziehen zu einem drahtförmigen, d. h. im Querschnitt immer noch ungefähr oder genau kreisförmigen Zwischen-Leiter umgeformt. Dieser Zwischen-Leiter wird eventuell noch um seine Längsachse verdreht, so dass die ursprünglich durch die Werkstücke 1 gebildeten Leiterteile und deren Kerne verdrillt werden. Der gerade, zueinander parallele oder verdrillte Kerne aufweisende Zwischen-Leiter wird nun in mehreren Walzdurchgängen gewalzt und zu einem länglichen, bandförmigen Leiter umgeformt. Die zuerst durch Strangpressen erfolgende Umformung des Ausgangs-Leiters 1 erfolgt dann zum Beispiel durch Warmverformung, wobei die Temperatur beim Warmverformen deutlich weniger als 800° C beträgt. Die restlichen Umformungsschritte können dann zum Beispiel durch Kaltverformungen, d. h. bei normaler Raumtemperatur erfolgen. Eventuell kann man jedoch den Leiter mindestens beim letzten Walzdurchgang oder bei den letzten Walzdurchgängen oder sogar bei allen Walzdurchgängen durch Warmverformen bei einer zum Beispiel 500° C bis 800° C betragenden Temperatur umformen. Der Leiter kann bei einer allfälligen, beim Walzen stattfindenden Warmverformung zum Beispiel durch gleichzeitig mit ihm zwischen den Walzen hindurch bewegte, metallische Schutzfolien gegen einen direkten Kontakt mit den Walzen geschützt werden. Für weitere Einzelheiten zu diesem Verfahren sei auf die schon in der Einleitung zitierte DE-A-44 21 163 verwiesen.

Der Leiter wird zwischen aufeinanderfolgenden Umformschritten und/oder nach der Beendigung der Umformung mindestens einer Wärmebehandlung - d. h. Reaktionsglühung - in Sauerstoff enthaltender Umgebung unterzogen. Dabei wird insbesondere zwischen den vorletzten und dem letzten Walzdurchgang eine solche Wärmebehandlung durchgeführt. Vorzugsweise findet jedoch bereits vor dem vorletzten Walzdurchgang sowie nach dem letzten Walzdurchgang noch mindestens je eine Wärmebehandlung statt.

Bei diesen Wärmebehandlungen wird das Material der Kerne des Leiters in an sich bekannter Weise mindestens zu einem grossen Teil und beispielsweise praktisch vollständig in die Phase Bi(2223) umgewandelt. Bei den Wärmbehandlungen findet auch ein Gasaustausch, insbesondere ein Sauerstoffaustausch statt, bei welchem die Kerne durch die mindestens zum Teil aus Silber bestehenden Mäntel und durch die Hüllen hindurch Gas, insbesondere Sauerstoff abgegeben und/oder aufnehmen. Ferner wird das ursprünglich in den Hüllen vorhandene Kupfer und/oder sonstige Metall mindestens teilweise und vorzugsweise mindestens zum grössten Teil oder vollständig oxidiert. Dagegen wird das in den Mänteln vorhandene Silber nicht oxidiert und bleibt also als Silber erhalten.

Der Ausgangs-Kern 3, die Ausgangs-Mäntel 4, 6 und die Ausgangs-Hülle 5 der ursprünglich zylindrischen Werkstücke 1 werden bei der Umformung der letzteren in sechseckförmige Werkstücke und bei der anschliessenen Umformung des Ausgangs-Leiters 21 zum Beispiel mindestens 100-mal verlängert. Die Querschnittsflächen der Werkstücke 1 werden dabei um einen Faktor verkleinert, der ungefähr gleich dem Quadrat des Verlängerungsfaktors ist. Im übrigen können die beim Umformen aus den mit Abschlusselementen oder durch Zusammenquetschen verschlossenen Endabschnitten der inneren Ausgangs-Mäntel 4 gebildeten Endabschnitte des Leiters abgeschnitten werden.

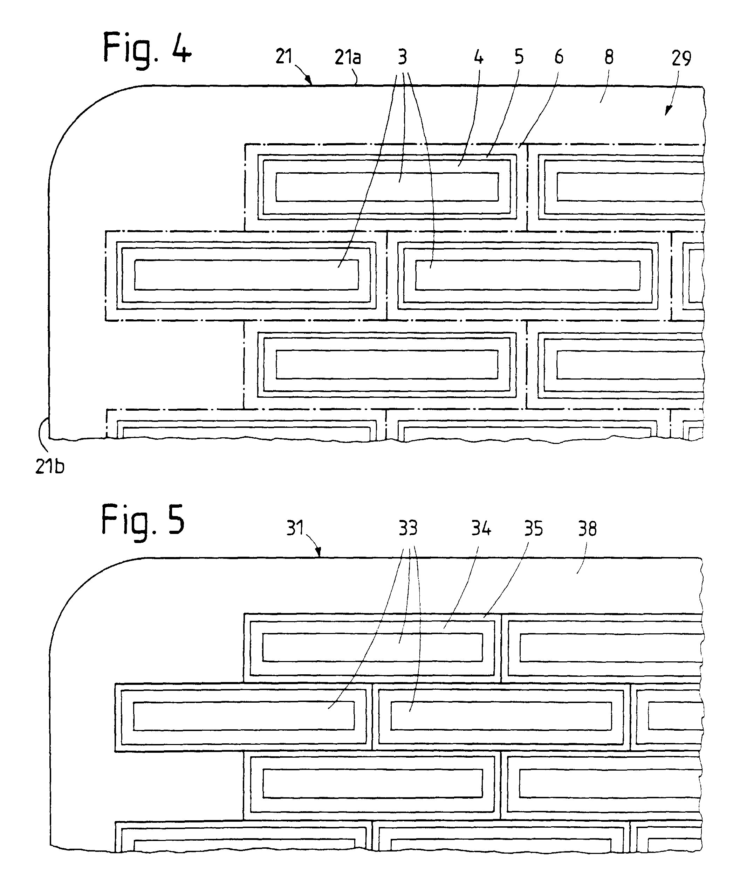

Der durch das beschriebene Verfahren hergestellte, in der Fig. 4 ersichtliche, fertige, längliche Leiter ist gleich wie der in der Fig. 3 gezeichnete Ausgangs-Leiter mit 21 bezeichnet. Ferner sind auch die Kerne, inneren Mäntel, Hüllen, äusseren Mäntel sowie der Bündel-Mantel des fertigen Leiters in der Fig. 4 mit den gleichen Nummern bezeichnet wie die entsprechenden Ausgangs-Teile in der Fig. 3.

Der in der Fig. 4 ersichtliche, fertige Leiter 21 ist bandförmig, im Querschnitt ungefähr rechteckförmig und hat zwei einander abgewandte, breitere, im wesentlichen ebene sowie zueinander parallele Flächen 21a und zwei einander abgewandte schmälere eventuell ebenfalls mindestens zum Teil ebene und/oder mindestens zum Teil konvex gebogene Flächen 21b. Die aus den Ausgangs-Kernen 3 entstandenen Kerne 3 des fertigen Leiters sind bei ausreichend tiefen Temperaturen supraleitend. Jeder Kern 3 des fertigen Leiters ist im Querschnitt von einem elektrisch leitenden Mantel 4 umschlossen. Jeder Mantel 4 des fertigen Leiters ist im Querschnitt von einer elektrisch isolierenden, sauerstoffdurchlässigen, mindestens zum grössten Teil aus Kupferoxid und/oder mindestens einem anderen Metalloxid bestehenden Hülle 5 umhüllt. Die äusseren Mäntel und der Bündel-Mantel 8 wurden bei den verschiedenen Umformungsschritten und den dabei erfolgten Umkristallisierungen zumindest weitgehend derart miteinander verbunden, dass sie beim fertigen Leiter praktisch zusammenhängen und eine in der Fig. 4 mit 29 bezeichnete, elektrisch leitende Matrix bilden. Die Umrisse der äusseren Mäntel 6 wurden in der Fig. 4 daher nur mit strichpunktierten Linien angedeutet. Die Kerne 3 wurden in der Fig. 4 als Rechtecke gezeichnet, deren breitere Seiten parallel zu den breiteren Flächen 21a des bandförmigen Leiters 21 sind. Es ist jedoch anzumerken, dass die Kerne 3 in Wirklichkeit in einer Endansicht und im Querschnitt unregelmässigere, von Rechtecken abweichende Formen haben. Entsprechendes gilt für die Mäntel 4 sowie 6 und die Hüllen 5.

Die Breite, d. h. die grössere, parallel zu den ebenen Abschnitten der breiteren Flächen 21a gemessene Querschnittsabmessung des fertigen Leiters 21 beträgt vorzugsweise mindestens 1 mm und zum Beispiel 2 mm bis 10 mm. Die rechtwinklig zur Breite gemessene Dicke des Leiters 21 beträgt vorzugsweise höchstens 30% sowie zum Beispiel ungefähr 5% bis 20% der Breite zum Beispiel 0,1 mm bis 0,5 mm.

Die Breiten, d.h. die parallel zu den breiteren Flächen 21a des fertigen Leiters 21 gemessenen, grösseren Querschnittsabmessungen der Kerne 3 betragen zum Beispiel ungefähr 30 µm bis 150 µm. Die Dicken, d.h. die rechtwinklig zu den Flächen 21a gemessenen, kleineren Querschnittsabmessungen der Kerne liegen zum Beispiel im Bereich von 5 µm bis 20 µm. Die inneren Mäntel 24 haben zum Beispiel Dicken von einigen Mikrometern. Die Dicken der isolierenden Hüllen liegen zum Beispiel im Bereich von 0,1 µm bis 2 µm.

Man kann aus dem fertigen Leiter 21 dann zum Beispiel eine Wicklung für einen Transformator wickeln.

Der in der Fig. 5 ersichtliche, längliche, bandförmige Leiter 31 besitzt mehrere, bei der Verwendung des Leiters supraleitende Kerne 33. Jeder Kern 33 ist im Querschnitt von einem elektrisch leitenden Mantel 34 umschlossen, der im Querschnitt seinerseits von einer elektrisch isolierenden Hülle 35 umhüllt ist. Der Leiter 31 besitzt ferner einen Bündel-Mantel 38, der das Bündel der Kerne 33 und der diesen zugeordneten Mäntel 34 sowie Hüllen 35 umschliesst. Der Leiter 31 besitzt keine den äusseren Mänteln 6 des Leiters 21 entsprechenden, äusseren Mäntel, so dass beim Leiter 31 verschiedenen Kernen 33 zugeordnete Hüllen 35 aneinander anstossen.

Die Leiter und das Verfahren für ihre Herstellung können noch auf andere Arten geändert werden. Man kann zum Beispiel beim Umformen eines Ausgangs-Leiters zu einem fertigen Leiter das Walzen durch Ziehen ersetzen, so dass der fertige Leiter, rundlich und im Querschnitt zum Beispiel ungefähr oder genau kreisförmig ist oder zum Beispiel ungefähr ein regelmässiges Sechseck bildet.

## Patentansprüche

1. Elektrischer Leiter mit mindestens zwei länglichen, supraleitenden Kernen (3, 33), von denen jeder im Querschnitt von einem elektrisch leitenden Mantel (4, 34) umschlossen ist, dadurch gekennzeichnet, dass jeder Mantel (4, 34) im Querschnitt von einer mindestens ein Metalloxid aufweisenden Hülle (5, 35) umhüllt ist, deren spezifischer elektrischer Widerstand grösser als derjenige des Mantels (4, 34) ist.

2. Leiter nach Anspruch 1, dadurch gekennzeichnet, dass jeder Kern (3, 33) eine Metalloxid-Phase und jeder Mantel (4, 34) Silber aufweist, wobei die Kerne (3, 33) zum Beispiel Oxide von Wismuth, Strontium, Calcium und Kupfer oder Oxide von Thallium, Strontium, Calcium und Kupfer oder Oxide von Yttrium, Barium und Kupfer oder Oxide von Quecksilber, Barium und Kupfer aufweisen und wobei die Mäntel (4, 34) zum Beispiel mindestens eine Schicht aus reinem Silber und/oder mindestens eine Schicht aus einer Silber-Legierung und/oder mindestens eine Schicht aus einem Silber-Komposit aufweisen.

3. Leiter nach Anspruch 1 oder 2, dadurch gekennzeichnt, dass jede Hülle (5, 35) sauerstoffdurchlässig und mindestens zum grössten Teil aus mindestens einem Oxid von einem ursprünglich duktilen, metallischen Material gebildet ist, wobei dieses metallische Material zum Beispiel derart duktil ist, dass die Querschnittsfläche einer mindestens zum grössten Teil aus dem metallischen Material bestehenden Hülle (5, 35) durch plastisches Umformen mindestens 10-mal verkleinert werden kann, ohne das die Hülle (5, 35) bricht.

4. Leiter nach einem der Ansprüche 1 bis 3, dadurch gekennzeichnet, dass die Hülle (5, 35) mindestens ein Oxid von mindestens einem der Metalle Kupfer, Aluminium, Nickel, Eisen, Magnesium, Titan, Zirkonium, Calcium, Zinn, Niob, Vanadium, Tantal, Hafnium aufweist.

5. Leiter nach einem der Ansprüche 1 bis 4, dadurch gekennzeichnet, dass die Hüllen (5, 35) ausschliesslich aus mindestens einem Oxid von mindestens einem der Metalle Kupfer, Aluminium, Nickel, Eisen, Magnesium, Titan, Zirkonium, Calcium, Zinn, Niob, Vanadium, Tantal, Hafnium oder aus einem Gemisch von mindestens einem dieser Oxide und mindestens einem dieser Metalle bestehen.

6. Leiter nach einem der Ansprüche 1 bis 5, dadurch gekennzeichnet, dass die Hüllen (5, 35) mindestens im wesentlichen aussschliesslich aus mindestens einem Metalloxid oder aus mehreren Metalloxiden bestehen.

7. Leiter nach einem der Ansprüche 1 bis 6, dadurch gekennzeichnet, dass die Hüllen (5, 35) porös und sauerstoffdurchlässig sind.

8. Leiter nach einem der Ansprüche 1 bis 7, dadurch gekennzeichnet, dass mindestens einige der Kerne (3, 33) texturiert sind, so dass im gleichen Kern (3, 33) vorhandene plättchenförmige Kristallite mindestens zum Teil ungefähr parallel zueinander und zur Längsrichtung des Kerns (3, 33) sind.

9. Leiter nach einem der Ansprüche 1 bis 8, dadurch gekennzeichnet, dass mindestens eine Querschnittabmessung jedes Kerns höchstens 50 µm und vorzugsweise höchstens 30 µm beträgt.

10. Leiter nach einem der Ansprüche 1 bis 9, dadurch gekennzeichnet, dass alle Kerne (3, 33), Mäntel (4, 34) und Hüllen (5, 35) zusammen einen Monolith bilden.

11. Leiter nach einem der Ansprüche 1 bis 4, dadurch gekennzeichnet, dass die Kerne (3, 33) und die diese im Querschnitt umschliessenden Mäntel (5, 35) sowie Hüllen (6, 36) verdrillt sind.

12. Leiter nach einem der Ansprüche 1 bis 11, dadurch gekennzeichnet, dass der spezifische elektrische Widerstand der Hüllen (5, 35) mindestens 10-mal, vorzugsweise mindestens 100-mal und zum Beispiel mindestens 1000-mal grösser ist als derjenige der von den Hüllen umschlossenen Mäntel (4, 34).

13. Leiter nach einem der Ansprüche 1 bis 12, dadurch gekennzeichnet, dass der elektrische Widerstand jeder Hülle (5, 35) in einer quer zur Längsrichtung des von ihr umschlossenen Kerns (3, 33) verlaufenden Richtung mindestens 10-mal, vorzugsweise mindestens 100-mal und noch besser mindestens 1000-mal grösser ist als der in der gleichen Richtung gemessene elektrische Widerstand des von der betreffenden Hülle umschlossenen Mantels (4, 34).

14. Leiter nach einem der Ansprüche 1 bis 13, dadurch gekennzeichnet, dass die Wärmeleitzahl der Hüllen (5, 35) bei einer absoluten Temperatur von 77 K mindestens 0,5 W/cm Celsius-Grad und vorzugsweise mindestens 1 W/cm Celsius-Grad ist.

15. Verfahren zur Herstellung eines elektrischen Leiters (21, 31) mit mindestens zwei länglichen, supraleitenden Kernen (3, 33), von denen jeder im Querschnitt von einem elektrisch leitenden Mantel (4, 34) umschlossen ist, dadurch gekennzeichnet, dass zur Bildung jedes Kerns (3, 33) des Leiters (21, 31) ein Werkstück (1) mit einem im Querschnitt von einem Mantel (4, 34) umschlossenen Kern (3) und mit einer den Mantel (4, 34) im Querschnitt umschliessenden, mindestens ein Metall aufweisenden Hülle (5, 35) gebildet wird und die Werkstücke (1) gemeinsam durch plastisches Verformen verlängert und mindestens einer Wärmebehandlung in sauerstoffhaltiger Umgebung unterzogen werden und dass das bzw. mindestens ein in der Hülle (5, 35) vorhandenes Metall bei der Wärmebehandlung mindestens zum Teil oxidiert wird so dass die Hülle (5, 35) beim fertigen Leiter (21, 31) einen grösseren spezifischen elektrischen widerstand hat als der Mantel (4, 34).

16. Verfahren nach Anspruch 15, dadurch gekennzeichnet, dass jede Hülle (5, 35) vor dem Oxidieren des bzw. mindestens eines in ihr vorhandenen Metalls duktil ist, so dass ihre Querschnittsfläche zum Beispiel durch plastisches Verformen mindestens 10-mal verkleinert werden kann, ohne dass die Hülle (5, 35) bricht.

17. Verfahren nach Anspruch 15 oder 16, dadurch gekennzeichnet, dass jede Hülle (5, 35) vor dem Oxidieren des bzw. mindestens eines in ihr vorhandenen Metalls mindestens eines der Metalle Kupfer, Aluminium, Nickel, Eisen, Magnesium, Titan, Zirkonium, Calcium, Zinn, Niob, Vanadium, Tantal, Hafnium aufweist.

18. Verfahren nach einem der Ansprüche 15 bis 17, dadurch gekennzeichnet, dass die Hülle (5, 35) vor dem Oxidieren ausschliesslich aus mindestens einem der Metalle Kupfer, Aluminium, Nickel, Eisen, Magnesium, Titan, Zirkonium, Calcium, Zinn, Niob, Vanadium, Tantal, Hafnium besteht.

19. Verfahren nach einem der Ansprüche 15 bis 18, dadurch gekennzeichnet, dass die ursprünglich in den Werkstücken (1) vorhandenen Kerne (3, 33) Metallverbindungen aufweisen, die bei der Wärmebehandlung bzw. den Wärmebehandlungen in eine supraleitende Metalloxid-Phase umgewandelt werden, dass die Hülle (5, 35) mindestens bei den Wärmebehandlungen für Sauerstoff durchlässig ist und dass die Mäntel (4, 34) Silber aufweisen, wobei die Mäntel (4, 34) des fertigen Leiters (21, 31) zum Beispiel mindestens eine Schicht reines Silber und/oder mindestens eine Schicht einer Silber-Legierung und/oder mindestens eine Schicht eines Silber-Komposits aufweisen.

20. Verfahren nach einem der Ansprüche 15 bis 19, dadurch gekennzeichnet, dass zur Bildung der Hüllen (5, 35) mindestens ein Metall elektrolytisch abgeschieden und an den Mänteln (4, 34) angelagert und/oder auf die Mäntel (4, 34) aufgedampft und/oder aufgesprüht wird und/oder ein Band um die Mäntel (4, 34) gewickelt wird.

21. Verfahren nach einem der Ansprüche 15 bis 20, dadurch gekennzeichnet, dass die bzw. mindestens eine Wärmebehandlung in einem sauerstoffhaltigen Gas erfolgt, dessen Druck mindestens 0,5 MPa und vorzugsweise mindestens 10 MPa beträgt, wobei der Partialdruck des im Gas vorhandenen Sauerstoffs vorzugsweise höchstens 50 kPa beträgt.

22. Verfahren nach einem der Ansprüche 15 bis 21, dadurch gekennzeichnet, dass die Werkstücke (1) vor der bzw. vor der letzten Wärmebehandlung und zum Beispiel vor allen Wärmebehandlungen miteinander verdrillt werden.

23. Verfahren nach einem der Ansprüche 15 bis 22, dadurch gekennzeichnet, dass die Hülle (5) bei der Bildung jedes Werkstücks (1) im Querschnitt mit einem Silber aufweisenden, äusseren Mantel (6) umschlossen wird.

24. Verfahren nach einem der Ansprüche 15 bis 23, dadurch gekennzeichnet, dass die Werkstücke (1) beim gemeinsamen Verformen in mehreren Verformungsschritten verformt werden, dass die bzw. mindestens eine Wärmebehandlung bei einer mindestens 790° C betragenden Temperatur zwischen verschiedenen Verformungs-Schritten und/oder nach diesen durchgeführt wird und dass die Dauer der Wärmebehandlung bzw. die gesamte Dauer der Wärmebehandlungen mindestens 50 Stunden und vorzugsweise mindestens 100 Stunden beträgt, wobei die gemeinsame Verformung der Werkstücke (1) vorzugsweise eine Umformung durch Walzen umfasst.

25. Verfahren nach einem der Ansprüche 15 bis 24, dadurch gekennzeichnet, dass im wesentlichen alles ursprünglich in den Hüllen (5, 35) vorhandene Metall oxidiert wird.

## Claims

1. Electrical conductor with at least two elongated, superconducting cores (3, 33), each of which is enclosed in cross-section by an electrically conducting sheath (4, 34), characterized in that each sheath (4, 34) is surrounded in cross-section by a casing (5, 35) which contains at least one metal oxide and whose specific electrical resistance is greater than that of the sheath (4, 34).

2. Conductor according to Claim 1, characterized in that each core (3, 33) contains a metal oxide phase and each sheath (4, 34) contains silver, the cores (3, 33) containing, for example, oxides of bismuth, strontium, calcium and copper or oxides of thallium, strontium, calcium and copper or oxides of yttrium, barium and copper or oxides of mercury, barium and copper, and the sheaths (4, 34) having, for example, at least one layer of pure silver and/or at least one layer of a silver alloy and/or at least one layer of a silver composite.

3. Conductor according to Claim 1 or 2, characterized in that each casing (5, 35) is oxygen-permeable and is formed, at least for the most part, from at least one oxide of an originally ductile, metallic material, this metallic material being, for example, ductile in a manner such that the cross-sectional area of a casing (5, 35) consisting at least for the most part of the metallic material can be reduced at least 10 times by plastic deformation, without the casing (5, 35) fracturing.

4. Conductor according to any of Claims 1 to 3, characterized in that the casing (5, 35) contains at least one oxide of at least one of the metals copper, aluminium, nickel, iron, magnesium, titanium, zirconium, calcium, tin, niobium, vanadium, tantalum and hafnium.

5. Conductor according to any of Claims 1 to 4, characterized in that the casings (5, 35) consist exclusively of at least one oxide of at least one of the metals copper, aluminium, nickel, iron, magnesium, titanium, zirconium, calcium, tin, niobium, vanadium, tantalum and hafnium or of a mixture of at least one of these oxides and at least one of these metals.

6. Conductor according to any of Claims 1 to 5, characterized in that the casings (5, 35) consist at least essentially exclusively of at least one metal oxide or of several metal oxides.

7. Conductor according to any of Claims 1 to 6, characterized in that the casings (5, 35) are porous and oxygen-permeable.

8. Conductor according to any of Claims 1 to 7, characterized in that at least some of the cores (3, 33) are textured so that lamellar crystallites present in the same core (3, 33) are at least in part approximately parallel to one another and to the longitudinal direction of the core (3, 33).

9. Conductor according to any of Claims 1 to 8, characterized in that at least one cross-sectional dimension of each core is at most 50 µm and preferably at most 30 µm.

10. Conductor according to any of Claims 1 to 9, characterized in that all cores (3, 33), sheaths (4, 34) and casings (5, 35) together form a monolith.

11. Conductor according to any of Claims 1 to 4, characterized in that the cores (3, 33) and the sheaths (5, 35) enclosing them in cross-section, and casings (6, 36), are twisted.

12. Conductor according to any of Claims 1 to 11, characterized in that the specific electrical resistance of the casings (5, 35) is at least 10 times, preferably at least 100 times and, for example, at least 1000 times greater than that of the sheaths (4, 34) enclosed by the casings.

13. Conductor according to any of Claims 1 to 12, characterized in that the electrical resistance of each casing (5, 35), in a direction transverse to the longitudinal direction of the core (3, 33) enclosed by said casing, is at least 10 times, preferably at least 100 times and even better at least 1000 times greater than the electrical resistance, measured in the same direction, of the sheath (4, 34) enclosed by the relevant casing.

14. Conductor according to any of Claims 1 to 13, characterized in that the coefficient of thermal conductivity of the casings (5, 35) at an absolute temperature of 77 K is at least 0.5 W/cm degrees Celsius and preferably at least 1 W/cm degrees Celsius.

15. Method of manufacturing an electrical conductor (21, 31) with at least two elongated, superconducting cores (3, 33), each of which is enclosed in cross-section by an electrically conducting sheath (4, 34), characterized in that a workpiece (1) having a core (3) surrounded in cross-section by a sheath (4, 34), and having a casing (5, 35) surrounding in cross-section the sheath (4, 34) and containing at least one metal, is formed for the formation of each core (3, 33) of the conductor (21, 31) and the workpieces (1) together are lengthened by plastic deformation and subjected to at least one heat treatment in an oxygen-containing environment, and that the or at least one metal present in the casing (5, 35) is oxidized at least in part during the heat treatment, so that the casing (5, 35) in the finished conductor (21, 31) has a greater specific electrical resistance than the sheath (4, 34).

16. Method according to Claim 15, characterized in that each casing (5, 35) is ductile before the oxidation of the or at least one metal present in it, so that its cross-sectional area can be reduced at least 10 times, for example by plastic deformation, without the casing (5, 35) fracturing.

17. Method according to Claim 15 or 16, characterized in that each casing (5, 35) contains at least one of the metals copper, aluminium, nickel, iron, magnesium, titanium, zirconium, calcium, tin, niobium, vanadium, tantalum and hafnium before the oxidation of the or at least one metal present in it.

18. Method according to any of Claims 15 to 17, characterized in that, before the oxidation, the casing (5, 35) consists exclusively of at least one of the metals copper, aluminium, nickel, iron, magnesium, titanium, zirconium, calcium, tin, niobium, vanadium, tantalum and hafnium.

19. Method according to any of Claims 15 to 18, characterized in that the cores (3, 33) originally present in the workpieces (1) contain metal compounds which are converted into a superconducting metal oxide phase during the heat treatment or the heat treatments, that the casing (5, 35) is oxygen-permeable, at least during the heat treatments, and that the sheaths (4, 34) contain silver, the sheaths (4, 34) of the finished conductor (21, 31) having, for example, at least one layer of pure silver and/or at least one layer of a silver alloy and/or at least one layer of a silver composite.

20. Method according to any of Claims 15 to 19, characterized in that, for the formation of the casings (5, 35), at least one metal is electrolytically deposited and collected on the sheaths (4, 34) and/or applied to the sheaths (4, 34) by vapor deposition and/or by spraying on and/or a ribbon is wound around the sheaths (4, 34).

21. Method according to any of Claims 15 to 20, characterized in that the or at least one heat treatment is carried out in an oxygen-containing gas whose pressure is at least 0.5 MPa and preferably at least 10 MPa, the partial pressure of the oxygen present in the gas preferably being at most 50 kPa.

22. Method according to any of Claims 15 to 21, characterized in that the workpieces (1) are twisted together before the or before the final heat treatment and, for example, before all heat treatments.

23. Method according to any of Claims 15 to 22, characterized in that, during the formation of such a workpiece (1), the casing (5) is enclosed in cross-section by a silver-containing, outer sheath (6).

24. Method according to any of Claims 15 to 23, characterized in that the workpieces (1) are formed by joint deformation in several deformation steps, that the or at least one heat treatment is carried out at a temperature of at least 790°C between different deformation steps and/or thereafter and that the duration of the heat treatment or the total duration of the heat treatments is at least 50 hours and preferably at least 100 hours, the joint deformation of the workpieces (1) preferably comprising forming by rolling.

25. Method according to any of Claims 15 to 24, characterized in that essentially all metal originally present in the casings (5, 35) is oxidized.

## Revendications

1. Conducteur électrique comprenant au moins deux âmes supraconductrices oblongues (3, 33), parmi lesquelles chacune, en vue en coupe, est entourée par une enveloppe électriquement conductrice (4, 34), caractérisé en ce que chaque enveloppe (4, 34), en vue en coupe, est entourée d'une gaine (5, 35) présentant au moins un oxyde métallique, et dont la résistance électrique spécifique est supérieure à celle de l'enveloppe (4, 34).

2. Conducteur selon la revendication 1, caractérisé en ce que chaque âme (3, 33) présente une phase d'oxyde métallique et chaque enveloppe (4, 34) présente de l'argent, les âmes (3, 33) présentant par exemple des oxydes de bismuth, de strontium, de calcium et de cuivre ou des oxydes de thallium, de strontium, de calcium et de cuivre ou des oxydes d'yttrium, de baryum et de cuivre ou des oxydes de mercure, de baryum et de cuivre, et les enveloppes (4, 34) présentant par exemple au moins une couche d'argent pur et/ou au moins une couche d'un alliage d'argent et/ou au moins une couche d'un composite d'argent.

3. Conducteur selon la revendication 1 ou 2, caractérisé en ce que chaque gaine (5,35) est perméable à l'oxygène et formée au moins en majeure partie d'au moins un oxyde d'un matériau métallique à l'origine ductile, ce matériau métallique étant par exemple ductile de façon telle que l'aire de section d'une gaine (5, 35), composée au moins en majeure partie du matériau métallique, peut être rétrécie au moins 10 fois par déformation plastique sans que la gaine (5, 35) casse.

4. Conducteur selon l'une des revendications 1 à 3, caractérisé en ce que la gaine (5, 35) présente au moins un oxyde d'au moins un des métaux cuivre, aluminium, nickel, fer, magnésium, titane, zirconium, calcium, étain, niobium, vanadium, tantale, hafnium.

5. Conducteur selon l'une des revendications 1 à 4, caractérisé en ce que les gaines (5, 35) se composent exclusivement d'au moins un oxyde d'au moins un des métaux cuivre, aluminium, nickel, fer, magnésium, titane, zirconium, calcium, étain, niobium, vanadium, tantale, hafnium, ou d'un mélange d'au moins un de ces oxydes et d'au moins un de ces métaux.

6. Conducteur selon l'une des revendications 1 à 5, caractérisé en ce que les gaines (5, 35) se composent au moins essentiellement exclusivement d'au moins un oxyde métallique ou plusieurs oxydes métalliques.

7. Conducteur selon l'une des revendications 1 à 6, caractérisé en ce que les gaines (5, 35) sont poreuses et perméables à l'oxygène.

8. Conducteur selon l'une des revendications 1 à 7, caractérisé en ce qu'au moins certaines des âmes (3,33) sont texturées, de sorte que des cristallites en forme de lamelles existant dans une même âme (3,33) sont au moins partiellement approximativement parallèles les unes aux autres et dirigées dans la direction longitudinale de l'âme (3, 33).

9. Conducteur selon l'une des revendications 1 à 8, caractérisé en ce qu'au moins une dimension en coupe de chaque âme est au plus égale à 50 µm et de préférence au plus égale à 30 µm.

10. Conducteur selon l'une des revendications 1 à 9, caractérisé en ce que toutes les âmes (3, 33), enveloppes (4, 34) et gaines (5, 35) forment ensemble un monolithe.

11. Conducteur selon l'une des revendications 1 à 4, caractérisé en ce que les âmes (3, 33) et les enveloppes (5, 35) et gaines (6, 36) entourant celles-ci en vue en coupe sont torsadées.

12. Conducteur selon l'une des revendications 1 à 11, caractérisé en ce que la résistance électrique spécifique des gaines (5, 35) est au moins 10 fois, de préférence au moins 100 fois et par exemple au moins 1 000 fois supérieure à celle des enveloppes (4, 34) entourées par les gaines.

13. Conducteur selon l'une des revendications 1 à 12, caractérisé en ce que la résistance électrique de chaque gaine (5, 35), dans une direction transversale à la direction longitudinale de l'âme (3, 33) entourée par celle-ci, est au moins 10 fois, de préférence au moins 100 fois et encore mieux au moins 1 000 fois supérieure à la résistance électrique, mesurée dans la même direction, de l'enveloppe (4, 34) entourée par la gaine concernée.

14. Conducteur selon l'une des revendications 1 à 13, caractérisé en ce que le coefficient de conductibilité thermique des gaines (5, 35), à une température absolue de 77 K, est au moins égal à 0,5 W/cm degré Celsius et de préférence au moins égal à 1 W/cm degré Celsius.

15. Procédé de fabrication d'un conducteur électrique (21, 31) présentant au moins deux âmes supraconductrices oblongues (3, 33), parmi lesquelles chacune, en vue en coupe, est entourée par une enveloppe électriquement conductrice (4, 34), caractérisé en ce que, pour former chaque âme (3, 33) du conducteur (21, 31), une pièce à usiner (1) présentant une âme (3) entourée en coupe d'une enveloppe (4, 34) et une gaine (5, 35) comportant au moins un métal et entourant en vue en coupe l'enveloppe (4, 34) est formée, et en ce que la pièce à usiner (1) est allongée conjointement par déformation plastique et est soumise à au moins un traitement thermique dans un environnement contenant de l'oxygène, et en ce que le ou au moins un métal présent dans la gaine (5, 35) est au moins en partie oxydé lors du traitement thermique, de sorte que la gaine (5, 35) du conducteur fini (21, 31) possède une résistance électrique spécifique supérieure à celle de l'enveloppe (4, 34).

16. Procédé selon la revendication 15, caractérisé en ce que chaque gaine (5, 35) est ductile avant l'oxydation du ou d'au moins un métal présent dans celle-ci, de sorte que son aire de section peut être rétrécie au moins 10 fois par exemple par déformation plastique, sans que la gaine (5, 35) ne casse.

17. Procédé selon la revendication 15 ou 16, caractérisé en ce que chaque gaine (5, 35), avant l'oxydation du ou d'au moins un métal présent dans celle-ci, présente au moins un des métaux cuivre, aluminium, nickel, fer, magnésium, titane, zirconium, calcium, étain, niobium, vanadium, tantale, hafnium.

18. Procédé selon l'une des revendications 15 à 17, caractérisé en ce que la gaine (5, 35), avant l'oxydation, se compose exclusivement d'au moins un des métaux cuivre, aluminium, nickel, fer, magnésium, titane, zirconium. calcium, étain, niobium, vanadium, tantale, hafnium.

19. Procédé selon l'une des revendications 15 à 18, caractérisé en ce que les âmes (3, 33) existant à l'origine dans les pièces à usiner (1) présentent des composés métalliques qui, lors du traitement thermique ou des traitement thermiques. sont transformées en une phase d'oxyde métallique supraconductrice, en ce que la gaine (5, 35) est perméable à l'oxygène au moins lors des traitements thermiques et en ce que les enveloppes (4, 34) présentent de l'argent, les enveloppes (4, 34) du conducteur fini (21, 31) présentant par exemple au moins une couche d'argent pur et/ou au moins une couche d'un alliage d'argent et/ou au moins une couche d'un composite d'argent.

20. Procédé selon l'une des revendications 15 à 19, caractérisé en ce que, pour former les gaines (5, 35), au moins un métal est appliqué par dépôt électrolytique sur les enveloppes (4, 34) et/ou appliqué sur les enveloppes (4, 34) par vaporisation et/ou pulvérisé et/ou une bande enroulée autour des enveloppes (4, 34).

21. Procédé selon l'une des revendications 15 à 20, caractérisé en ce que le ou au moins un traitement thermique est réalisé dans un gaz contenant de l'oxygène et dont la pression est au moins égale à 0,5 MPa et de préférence au moins égale à 10 MPa, la pression partielle de l'oxygène présent dans le gaz étant de préférence au plus égale à 50 kPa.

22. Procédé selon l'une des revendications 15 à 21, caractérisé en ce que les pièces à usiner (1) sont torsadées ensemble avant le ou avant le dernier traitement thermique et par exemple avant tous les traitements thermiques.

23. Procédé selon l'une des revendications 15 à 22, caractérisé en ce que la gaine (5) est entourée, en vue en coupe, lors de la formation de chaque pièce à usiner (1), par une enveloppe externe (6) contenant de l'argent.

24. Procédé selon l'une des revendications 15 à 23, caractérisé en ce que les pièces à usiner (1) sont déformés lors d'une déformation conjointe en plusieurs étapes de déformation, en ce que le ou au moins un traitement thermique est réalisé à une température au moins égale à 790 °C entre différentes étapes de déformation et/ou après celles-ci, et en ce que la durée du traitement thermique ou la durée totale des traitements thermiques est au moins égale à 50 heures et de préférence au moins égale à 100 heures, la déformation conjointe des pièces à usiner (1) comprenant de préférence une déformation par laminage.

25. Procédé selon l'une des revendications 15 à 24, caractérisé en ce qu'essentiellement tout le métal originellement présent dans les gaines (5, 35) est oxydé.
